# EUROPEAN PATENT APPLICATION

(11) **EP 4 560 657 A2**
(43) Date of publication of application: **28.05.2025**
(21) Application number: 24212075.6
(22) Date of filing: 11.11.2024
(51) Int. Cl.: H01F 27/02, H01F 27/06, H02M 7/00, H05K 5/00, H05K 5/02, H05K 7/20, H01F 27/04

(54) **INVERTER AND CABLE-FREE INDUCTOR**

(30) Priority: 25.11.2023 CN 202311601270
(71) Applicant: Huawei Digital Power Technologies Co., Ltd., Shenzhen, Guangdong 518043 (CN)
(72) Inventor: XU, Zhongda, Shenzhen, 518043 (CN); FENG, Haoran, Shenzhen, 518043 (CN); ZHANG, Jiangteng, Shenzhen, 518043 (CN)
(74) Representative: Gill Jennings & Every LLP

(57) **Abstract**

This application provides an inverter and a cable-free inductor. The inverter includes a top housing, a bottom housing, a power inductor, and a main circuit board. The top housing and the bottom housing are enclosed to form an accommodation cavity, the main circuit board is mounted in the accommodation cavity, and a plane on which the main circuit board is located and a plane on which the top housing is located are both perpendicular to a first direction. The bottom housing includes a through hole. Along the first direction, the power inductor passes through the through hole to be connected to the main circuit board. The power inductor includes an inductor housing, an inductor cover plate, a magnetic core, and a coil. The inductor housing and the inductor cover plate are enclosed to form accommodation space, the magnetic core and the coil are located in the accommodation space, and the coil is wound around the magnetic core. The inductor cover plate includes a cover plate body and a connection bracket. The cover plate body is of a plate-like shape, and the cover plate body is connected to an opening of the inductor housing. The connection bracket is located on a side that is of the inductor cover plate and that is away from the coil, and the power inductor is configured to be rigidly connected to a main circuit board through the connection bracket. According to this application, a connection cable may not be needed, so that a production period is shortened, and miniaturization of an apparatus is facilitated.

## Description

### TECHNICAL FIELD

This application relates to the field of power electronics, and in particular, to an inverter and a cable-free inductor.

### BACKGROUND

As people become increasingly concerned about global environmental issues, a new energy industry has developed rapidly in recent years. As one type of new energy, solar energy is widely used thanks to features such as richness, easy accessibility, and cleanness. As one of important components of a solar power generation system, a photovoltaic inverter can convert a direct current generated by a photovoltaic solar panel into a 220 V, 50 Hz alternating current or another type of alternating current, to meet power-consuming requirements of various devices. However, currently, there are a large quantity of connection cables inside the photovoltaic inverter, an installation process is complex, and a cable connection fault is prone to occur. The connection cables inside the inverter need to be connected to electrical elements through various wiring terminals or pins, resulting in a large size of the entire photovoltaic inverter. Currently, the size of the photovoltaic inverter is large, and heat dissipation effect is poor. In addition, an inductor is an indispensable electrical element in the photovoltaic inverter. In a production process of the photovoltaic inverter, a potting process of the inductor usually occupies a large amount of production time.

### SUMMARY

This application provides a cable-free inductor and an inverter using the inductor, to avoid a cable connection error, simplify an installation procedure, shorten a production period, and facilitate device miniaturization.

According to a first aspect, this application provides an inverter, including a top housing, a bottom housing, a power inductor, and a main circuit board. The top housing and the bottom housing are enclosed to form an accommodation cavity. The main circuit board is mounted in the accommodation cavity, and a plane on which the main circuit board is located is parallel to a plane on which the top housing is located. The bottom housing includes a through hole. The through hole is configured for the power inductor to pass through the bottom housing along a first direction and to connect to the main circuit board. The first direction is a direction perpendicular to the plane on which the main circuit board is located.

In this implementation, the power inductor is detachable relative to the inverter, production processes of the power inductor and the inverter do not interfere with each other, and a total production period of the inverter may not be restricted by a solidification time of a potting compound of the power inductor. Therefore, overall production efficiency of the inverter is improved. The top housing, the main circuit board, and the power inductor are arranged in a stacked manner along the first direction, which reduces a projection area of the entire inverter in the first direction and facilitates device miniaturization, compared with a manner in which the power inductor and the main circuit board are arranged in parallel. The power inductor is directly connected to the main circuit board. Therefore, a cable is eliminated, a possible cable connection error is avoided, installation process of the power inductor is simplified, and process aesthetics of the inverter is improved.

With reference to the first aspect, in an implementation, the power inductor includes an inductor housing, an inductor cover plate, a magnetic core, and a coil. The inductor housing and the inductor cover plate are enclosed to form accommodation space, the magnetic core and the coil are located in the accommodation space, and the coil is wound around the magnetic core. The inductor cover plate includes a connection bracket. The connection bracket is located on a side that is of the inductor cover plate and that is away from the coil, and the connection bracket is configured to support a conductive component between the power inductor and the main circuit board.

In this implementation, the inside and the outside of the power inductor are isolated from each other by the inductor housing and the inductor cover plate. The magnetic core and the coil that generate heat are placed inside the power inductor, and the inductor cover plate outside the power inductor is connected to the main circuit board through the connection bracket. The connection bracket may provide accommodation space for a connector, and can also support the conductive component of the power inductor. In addition, the connection bracket may be adaptively adjusted based on a specification of the inductor, to facilitate design and installation.

With reference to the first aspect, in an implementation, the inductor cover plate includes a coil through hole and a conductive metal strip. The coil passes through the inductor cover plate through the coil through hole. One end of the conductive metal strip is connected to the main circuit board, and the other end of the conductive metal strip is connected to the coil. The power inductor is electrically connected to the main circuit board through the conductive metal strip.

In this implementation, the coil of the power inductor passes through the inductor cover plate and leads out a coil end portion, and is connected to the conductive metal strip that is used as a transition, to finally implement an electrical connection to the main circuit board. The coil end portion and the conductive metal strip are both rigid structures, and may be connected through welding, a buckle, or the like. The installation process is simple, and connection reliability is high. In addition, the conductive metal strip is attached to the connection bracket and is supported by the connection bracket. Even if the inverter experiences vibration during transportation and installation, the connection between the power inductor and the main circuit board is still reliable.

With reference to the first aspect, in an implementation, the inductor cover plate includes a magnetic ring. The magnetic ring is fastened to the cover plate body, the magnetic ring is disposed around the connection bracket, and a power line formed by connecting the conductive metal strip and the coil passes through the magnetic ring. In this implementation, to suppress common-mode interference, the magnetic ring is directly integrated into the inductor cover plate. Compared with the conventional technology of inductor cable connection, a process in which the magnetic ring is sleeved on an inductor cable is omitted, and less installation procedure is performed.

With reference to the first aspect, in an implementation, the connection bracket includes a hollow structure. The hollow structure is provided with a nut groove, and a nut is disposed in the nut groove. One end of the main circuit board and one end of the conductive metal strip each include a through-hole structure. The through-hole structure is configured to allow a bolt to pass through and be fastened to the nut, and the power inductor is rigidly connected to the main circuit board through the conductive metal strip.

In this implementation, the main circuit board, the conductive metal strip, and the connection bracket are connected through the bolt. Reliability is high, and the connection is convenient. In addition, an electrical connection and the rigid connection between the power inductor and the main circuit board are both integrated into the conductive metal strip. The solution is simple, and feasibility is high.

The connection bracket is of a square columnar structure. A fixed side wall is provided on a peripheral edge that is of the connection bracket and that is close to a surface of the main circuit board, the fixed side wall is a protrusion structure with a notch, the fixed side wall is distributed on three sides of the peripheral edge, and the fixed side wall is distributed on a part of one side of the peripheral edge. In this implementation, a dent used for positioning and accommodating the conductive metal strip is formed on the top of the fixed side wall and the connection bracket. The fixed side wall allows the conductive metal strip to move to the dent only along the first direction. In addition, once the connection bracket is fastened to the main circuit board through the bolt, the fixed side wall limits the conductive metal strip from sliding outs of the dent. This design makes installation of the conductive metal strip and the connection bracket simple, convenient, and practical.

With reference to the first aspect, in an implementation, the conductive metal strip is of a Z-shaped plate-like structure. A port of the coil is of a plate-like structure, the conductive metal strip is perpendicular to the port of the coil, the port of the coil passes through the conductive metal strip, and the port of the coil is fastened to the conductive metal strip.

In this implementation, as a transition element between the coil and the main circuit board, the conductive metal strip needs to maintain the close connection between the two ends of the conductive metal strip and the main circuit board and the coil, to ensure that a power line between the coil and the main circuit board is maintained. The conductive metal strip is designed as the Z-shaped structure with two bending portions, so that the conductive metal strip may deform when a magnitude of squeezing force from the first direction changes. In this way, even if creep effect occurs on the main circuit board because of the deformation of the inverter due to long-time working, the conductive metal strip may still be in close contact with the main circuit board, ensuring that the power line is not disconnected. In addition, the conductive metal strip is attached to the connection bracket, and connects the plate-like coil end portion to the main circuit board.

The port of the coil may alternatively be a plate-like structure with a buckle interface. The port of the coil includes a buckle and a port plate. The port plate is of a plate-like structure, one end of the port plate is connected to the coil, and the other end of the port plate is connected to the buckle. The buckle and the port plate are integrally formed, two buckles are perpendicular to the port plate and parallel to the conductive metal strip, the two buckles are bent in two opposite directions, and at least one of the two buckles is located on a side that is of the conductive metal strip and that faces the main circuit board. One end that is of the port of the coil and that is connected to the conductive metal strip is split from the middle, and split parts are bent in two opposite directions, to form a buckle structure. The buckle structure passes through the conductive strip and is clamped with the conductive metal strip. Compared with a welding connection used between the conductive metal strip and the port of the coil when the coil end portion is of the plate-like structure, the buckle connection used between the conductive metal strip and the coil end portion greatly improves connection reliability between the conductive metal strip and the coil end portion.

The bending portion of the conductive metal strip may be provided with a bending portion notch, to enhance a deformation capability of the conductive metal strip.

With reference to the first aspect, in an implementation, the power inductor includes a sealing groove and a sealing ring. The sealing groove is provided on a periphery on one side that is of the inductor housing and that is close to the inductor cover plate, the sealing ring is embedded in the sealing groove, and the sealing ring is configured to seal the bottom housing and the inductor housing. The sealing ring may ensure sealing reliability of a joint between the inverter and the power inductor.

With reference to the first aspect, in an implementation, the power inductor includes a potting compound. The potting compound is potted in the accommodation space, and the potting compound is configured to immerse the magnetic core and the coil. The potting compound may accelerate release of heat generated by the magnetic core and coil, and improve heat dissipation capability of the power inductor.

With reference to the first aspect, in an implementation, heat-dissipation fins are disposed on outer surfaces of both the bottom housing and the inductor housing. The heat-dissipation fins may enhance a capability of the power inductor to dissipate heat to an external environment.

With reference to the first aspect, in an implementation, the inductor housing and the inductor cover plate are detachable from each other, and the inductor housing is rigidly connected to the inductor cover plate through a bolt. The detachable inductor housing and inductor cover plate may make a potting process simpler. A bolt connection manner may ensure connection reliability between the inductor housing and the inductor cover plate.

With reference to the first aspect, in an implementation, the inductor housing is rigidly connected to the bottom housing through a bolt. In addition to a rigid connection and an electrical connection between the power inductor and the main circuit board, the inductor housing of the power inductor is further connected to the bottom housing of the inverter, so that a connection reliability between the power inductor and the main circuit board is enhanced, and a surface of the bottom housing of the inverter and a surface of the inductor housing are combined into a continuous surface. The inductor housing and the bottom housing are connected through the bolt, which may squeeze a sealing ring, and ensure that the inside of the inverter is isolated from an external environment.

With reference to the first aspect, in an implementation, the inverter includes the top housing, the bottom housing, and the main circuit board. The top housing is of a plate-like structure. The bottom housing is of a groove-shaped structure. The main circuit board is disposed parallel to the top housing, and is mounted in an internal cavity formed by enclosing the top housing and the bottom housing. The internal cavity is divided into a first cavity and a second cavity by the main circuit board. The first cavity is a cavity formed between the top housing and a side that is of the main circuit board and that faces the top housing. The second cavity is a cavity formed between the bottom housing and the side that is of the main circuit board and that faces the bottom housing. A main electrical element of the inverter is mounted in the second cavity. Such a main electrical element, for example, a power module or a capacitor element, has a relatively large size and a high heat dissipation requirement. An electrical element that has a small size and a low heat dissipation requirement, for example, a signal indicator, a surface mount capacitor, and a surface mount resistor, is mounted in the first cavity. In this way, a size of an entire photovoltaic inverter 20 can be reduced to a maximum extent, and the heat dissipation requirement of the electrical element is also ensured.

With reference to the first aspect, in an implementation, the inductor housing includes the heat-dissipation fins, a housing connection portion, and positioning pins. The housing connection portion is located on a periphery of an opening of the inductor housing, and is of an annular strip-like structure. A center of the annular strip-like structure is configured to mount the magnetic core and the coil that are of the power inductor. The housing connection portion and the heat-dissipation fins are of an integrated structure. The annular strip-like structure has a specific width, on which positioning pins are designed. There are two positioning pins respectively distributed on opposite sides of the housing connection portion and configured for positioning in a process in which the power inductor is mounted on the inverter. The positioning pin structure may be configured for positioning in a process in which the power inductor is mounted on the inverter.

With reference to the first aspect, in an implementation, a part that is of the power inductor and that is immersed in the potting compound includes the coil, the magnetic core, and a framework. There are two coils. Each coil leads out two coil end portions. The framework is partially fastened to the cover plate body. The middle of the framework is configured to: accommodate and fasten the magnetic core, and isolate direct contact between the coil and the magnetic core. The coil is wound on the magnetic core.

According to a second aspect, this application provides an inductor apparatus, including an inductor housing, an inductor cover plate, a magnetic core, and a coil. The inductor housing and the inductor cover plate are enclosed to form accommodation space, the magnetic core and the coil are located in the accommodation space, and the coil is wound around the magnetic core. The inductor cover plate includes a connection bracket. The connection bracket is located on a side that is of the inductor cover plate and that is away from the coil, and the connection bracket is configured to support a conductive component between the inductor apparatus and a circuit board.

With reference to the second aspect, in an implementation, the inductor cover plate includes a coil through hole and a conductive metal strip. The coil passes through the inductor cover plate through the coil through hole. One end of the conductive metal strip is connected to the circuit board, and the other end of the conductive metal strip is connected to the coil. The power inductor is electrically connected to the circuit board through the conductive metal strip.

With reference to the second aspect, in an implementation, the inductor cover plate includes a magnetic ring. The magnetic ring is fastened to the cover plate body, the magnetic ring is disposed around the connection bracket, and a power line formed by connecting the conductive metal strip and the coil passes through the magnetic ring.

With reference to the second aspect, in an implementation, the connection bracket includes a hollow structure. The hollow structure is provided with a nut groove, and a nut is disposed in the nut groove. One end of the conductive metal strip includes a through-hole structure. The through-hole structure is configured to allow a bolt to pass through and be fastened to the nut, and the power inductor is rigidly connected to the circuit board through the conductive metal strip.

With reference to the second aspect, in an implementation, the conductive metal strip is of a Z-shaped plate-like structure. A port of the coil is of a plate-like structure, the conductive metal strip is perpendicular to the port of the coil, the port of the coil passes through the conductive metal strip, and the port of the coil is fastened to the conductive metal strip.

The port of the coil may alternatively be a plate-like structure with a buckle interface. The port of the coil includes a buckle and a port plate. The port plate is of a plate-like structure, one end of the port plate is connected to the coil, and the other end of the port plate is connected to the buckle. The buckle and the port plate are integrally formed, two buckles are perpendicular to the port plate and parallel to the conductive metal strip, the two buckles are bent in two opposite directions, and at least one of the two buckles is located on a side that is of the conductive metal strip and that faces the main circuit board.

For the technical solution in the second aspect and technical effects brought by the technical solution, refer to the first aspect. Details are not described herein again.

### BRIEF DESCRIPTION OF DRAWINGS

FIG. 1 is a diagram of a photovoltaic power generation system according to an embodiment of this application;
FIG. 2 is a diagram of a structure of a photovoltaic inverter 20 according to an embodiment of this application;
FIG. 3 is a front view of a photovoltaic inverter 20 according to an embodiment of this application;
FIG. 4 is a side view of a photovoltaic inverter 20 according to an embodiment of this application;
FIG. 5 is a diagram of a cross-sectional structure of the photovoltaic inverter 20 shown in FIG. 3;
FIG. 6 is an axonometric diagram of a second power inductor according to an embodiment of this application;
FIG. 7 is a side view of a second power inductor in which an inductor housing is hidden according to an embodiment of this application;
FIG. 8 is a front view of a second power inductor in which an inductor housing is hidden according to an embodiment of this application;
FIG. 9 is an axonometric diagram of an inductor cover plate according to an embodiment of this application;
FIG. 10 is a diagram of a structure of a connection bracket according to an embodiment of this application;
FIG. 11 is diagram of a structure of a connection between a conductive metal strip and a coil end portion according to an embodiment of this application; and
FIG. 12 is an axonometric diagram of a first power inductor according to an embodiment of this application.

### DESCRIPTION OF EMBODIMENTS

The following describes technical solutions of this application with reference to accompanying drawings.

In embodiments of this application, prefix words such as "first", "second", and "third" are used only to distinguish between different described objects, and do not constitute any limitation on locations, a sequence, priorities, a quantity, content, or the like of the described objects. In embodiments of this application, use of the prefix words, for example, an ordinal number, used to distinguish between the described objects does not constitute a limitation on the described objects. For descriptions of the described objects, refer to the descriptions of the context in the claims or embodiments. The use of such prefix words should not constitute a redundant limitation. In addition, in the descriptions of embodiments, unless otherwise specified, "a plurality of" means two or more.

In embodiments of this application, an orientation or a position relationship indicated by terms "up", "down", "left", "right", "front", "back", "top", "bottom", "inside", "outside", and the like is based on an orientation or a position relationship shown in the accompanying drawings, and is merely intended to describe this application and simplified the descriptions, but does not indicate or imply that a specified apparatus or element needs to have a specific orientation or be constructed and operated in a specific orientation, and therefore cannot be understood as a limitation on this application.

Reference to "some embodiments" or the like described in this specification indicates that one or more embodiments of this application include a specific feature, structure, or characteristic described with reference to embodiments. Therefore, statements such as "in some embodiments" or the like that appear at different places in this specification do not necessarily mean reference to a same embodiment, instead, they mean "one or more but not all of embodiments", unless otherwise specifically emphasized in another manner. Terms "include", "have", and their variants all mean "include but are not limited to", unless otherwise specifically emphasized in another manner.

In embodiments of this application, a same reference numeral represents a same component or a same part or component. In embodiments of this application, for a plurality of same parts or components, only one of the parts or components may be used as an example to mark a reference numeral in the accompanying drawings. For other same parts or components, reference numerals are also applicable. In addition, a size of the part or component shown in the accompanying drawings is merely an example.

For ease of understanding, the following first explains and describes related technical terms and English abbreviations in embodiments of this application.

Photovoltaic inverter: An inverter is a converter that converts a direct current into a constant-frequency and constant-voltage alternating current or a frequency-modulated and voltage-regulated alternating current. The photovoltaic inverter is an inverter that converts a variable direct current generated by a solar panel (also referred to as a photovoltaic panel) into a mains frequency alternating current.

Power conversion system: PCS, power conversion system. The power conversion system can control charging and discharging processes of a battery and perform alternating current-direct current conversion, and can directly supply power to an alternating current load when there is no power grid.

Uninterruptible power supply: UPS, uninterruptible power supply. The uninterruptible power supply is an apparatus connected between an electronic device and a power supply, and is configured to prevent the electronic device from being powered off due to peak demand, current control, or the like.

Parallel: "Parallel" defined in this application is not limited to absolute parallelism. A definition of "parallel" may be understood as basic parallelism. A case in which there is no absolute parallelism due to assembly tolerance, design tolerance, impact of structural flatness, or another factor is allowed.

Perpendicular: Perpendicular defined in this application is not limited to absolute perpendicular intersection (an included angle is 90 degrees). A case in which there is no absolute perpendicular intersection due to assembly tolerance, design tolerance, impact of structural flatness, or another factor is allowed. An error within a small angle range is allowed. For example, an assembly error range of 80 degrees to 100 degrees may be understood as being perpendicular.

PV: Short for photovoltaic, which means generating power by utilizing solar energy. A PV port means a port connected to a photovoltaic module.

Common-mode interference: The common-mode interference means that amplitude of an interference voltage on a signal cable and amplitude of an interference voltage on a return cable of the signal cable (generally also referred to as signal ground cable) are the same. The voltage herein uses any nearby object (ground, metal chassis, reference ground plane, or the like) as reference potential. An interference current loop flows in a loop including a conducting wire and a reference object.

Creep effect: It is slow and permanent deformation of a solid material under stress, and is a result of long-term stress that is less than yield strength of the material.

Embodiments of this application provide a cable-free inductor and an application of the cable-free inductor in a power conversion apparatus.

The inductor includes an inductor housing, an inductor cover plate, a magnetic core, and a coil. The inductor housing and the inductor cover plate are enclosed to form accommodation space, the magnetic core and the coil are located in the accommodation space, and the coil is wound around the magnetic core. The inductor cover plate includes a cover plate body and a connection bracket. The cover plate body is of a plate-like shape, and the cover plate body is connected to an opening of the inductor housing. The connection bracket is located on a side that is of the inductor cover plate and that is away from the coil, and a power inductor is configured to be electrically and rigidly connected to a circuit board through a conductive metal strip.

The inductor may be used in a power conversion apparatus. The power conversion apparatus includes a top housing, a bottom housing, the power inductor, and a main circuit board. The top housing and the bottom housing are enclosed to form an accommodation cavity, the main circuit board is mounted in the accommodation cavity, and a plane on which the main circuit board is located and a plane on which the top housing is located are both perpendicular to a first direction. The bottom housing includes a through hole. Along the first direction, the power inductor passes through the through hole to be connected to the main circuit board.

The cable-free inductor provided in embodiments of this application can be independently detached relative to the power conversion apparatus. Therefore, production processes of the cable-free inductor and the power conversion apparatus do not interfere with each other, so that a production period of the entire power conversion apparatus can be shortened. In addition, the cable-free inductor is directly connected to the circuit board, and a cable is omitted. In this way, a possibility of a cable connection error caused by the cable is eliminated, installation procedures of the power inductor are simplified, a size of the entire power conversion apparatus is reduced, and process aesthetics of the power conversion apparatus is improved.

The cable-free inductor provided in embodiments of this application may be used in various power conversion apparatuses requiring the power inductor. The power conversion apparatus including the cable-free inductor in this application may be used in application scenarios such as household green power, industry green power, and a photovoltaic power station. The power conversion apparatus includes a photovoltaic inverter, a power conversion system PCS, and an uninterruptible power supply UPS.

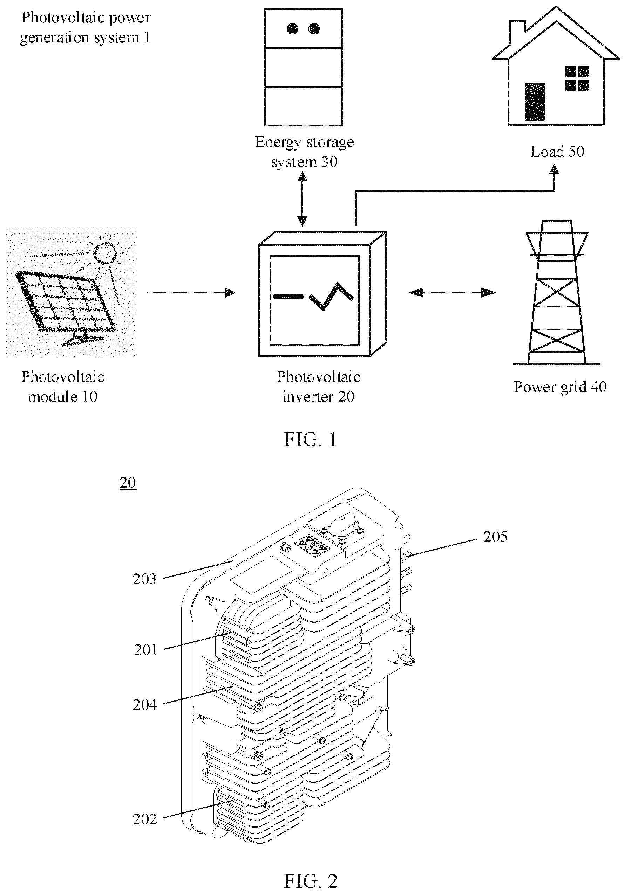

FIG. 1 is a diagram of a photovoltaic power generation system according to an embodiment of this application. In an implementation, apparatuses in a photovoltaic power generation system 1 include a photovoltaic module 10, a photovoltaic inverter 20, and an energy storage system 30. Optionally, the photovoltaic power generation system 1 may further include a power grid 40 and a load 50.

Specifically, the photovoltaic inverter 20 can convert a direct current from the photovoltaic module 10 into an alternating current, and transmit the alternating current to the power grid 40 or the load 50. The photovoltaic inverter 20 can transmit the direct current from the photovoltaic module 10 to the energy storage system 30, to charge the energy storage system 30. Energy flows between the photovoltaic inverter 20 and the energy storage system 30 and between the photovoltaic inverter 20 and the power grid 40 are bidirectional. In other words, the photovoltaic inverter 20 can convert a direct current from the energy storage system 30 into an alternating current, and transmit the alternating current to the power grid 40 or the load 50; and the photovoltaic inverter 20 can transmit an alternating current from the power grid 40 to the load 50, or convert the alternating current into a direct current and then transmit the direct current to the energy storage system 30 for charging.

It may be understood that, when the photovoltaic power generation system 1 includes the photovoltaic module 10, the photovoltaic inverter 20, and the energy storage system 30, the photovoltaic inverter 20 is mainly configured to connect the photovoltaic module 10 to the energy storage system 30, to charge the energy storage system 30. When the photovoltaic power generation system 1 includes the photovoltaic module 10, the photovoltaic inverter 20, the energy storage system 30, the power grid 40, and the load 50, the photovoltaic inverter 20 can be configured to connect the foregoing apparatuses. For example, the photovoltaic inverter 20 connects the photovoltaic module 10 to the energy storage system 30. The photovoltaic inverter 20 connects the photovoltaic module 10 to the power grid 40. The photovoltaic inverter 20 connects the photovoltaic module 10 to the load 50. The photovoltaic inverter 20 connects the load 50 to the energy storage system 30.

The energy storage system 30 in the photovoltaic power generation system 1 can store and release electric energy. For example, the energy storage system 30 may store direct current electric energy from the photovoltaic module 10, and the energy storage system 30 may supply power to the power grid 40 or the load 50 by using the photovoltaic inverter 20. Therefore, application scenarios of the energy storage system 30 are wide, including but not limited to a residential scenario, an industry green power scenario, a smart photovoltaic power station scenario, and the like.

It may be learned from the foregoing descriptions that the photovoltaic inverter 20 is a converter that can implement mutual conversion between a direct current and an alternating current. Specifically, the photovoltaic inverter 20 may include two direct current ports (for example, a direct current port 3 and a direct current port 2) and one alternating current port. The two direct current ports are respectively configured to be connected to the photovoltaic module 10 and the energy storage system 30. The alternating current port may be configured to be connected to the power grid 40 and the load 50. For example, the direct current port 3 is configured to be connected to the photovoltaic module 10, and the direct current port 2 is configured to be connected to the energy storage system 30. The alternating current port may be configured to output an alternating current, and the output alternating current may be distributed by using a distribution box, for example, distributed to the power grid 40 and the load 50.

The photovoltaic module 10 may feed the power grid 40 and supply power to the load 50 through the direct current port 3. The energy storage system 30 may supply power to the load 50 through the direct current port 2. The power grid 40 may supply power to the load 50 through the alternating current port. In other words, the photovoltaic inverter 20 is a connection hub between the load 50 and an energy module (which may include the photovoltaic module 10, the energy storage system 30, and the power grid 40).

A power inductor is one of main elements that generate heat in a power conversion apparatus (including the foregoing photovoltaic inverter). In this case, a huge heat dissipation requirement of the power inductor needs to be considered when the power inductor is designed. The following two manners are usually used to enhance a heat dissipation capability of a power inductor inside a power conversion apparatus that uses a natural heat dissipation manner. In manner 1, the power conversion apparatus includes an entire machine structural member and an inductor cavity, and the inductor cavity can be independently detached relative to the entire machine structural member. The power inductor is potted in the inductor cavity by using a potting compound having a good heat conduction capability, and the power inductor leads out a cable to be connected to a board in the entire machine structural member. To meet a requirement for an IP65 protection level, a sealing rubber strip further needs to be added at a joint between the inductor cavity and the entire machine structural member. In manner 2, an entire machine structural member and an inductor cavity are of an integrated structure. The inductor cavity is located at a position that is separately reserved in the entire machine structural member. The power inductor is potted in the inductor cavity, and the power inductor leads out a cable to be connected to a board in the entire machine structural member.

However, there are some apparent problems in each of the two manners. In the manner 1, the inductor cavity is disposed outside the entire machine structural member, and sealing between the inductor cavity and the entire machine structural member needs to be performed by using the sealing rubber strip or in another sealing manner. In this case, additional sealing costs are increased, sealing reliability is low, and a size of the entire power conversion apparatus is large. In addition, the power inductor and the board are connected through the cable. In this case, process aesthetics of the device is low, and there may be a possibility of a cable connection error. In the manner 2, the position needs to be reserved in the entire machine structural member for the inductor cavity. In this case, a size of the entire power conversion apparatus is also large. In addition, the cable connection leads to low process aesthetics of the device, and there may be a possibility of a cable connection error. Moreover, during manufacturing of the power conversion apparatus, the power inductor and the potting compound need to be first potted in the inductor cavity, and another element in the power conversion apparatus can be assembled only after the potting compound is completely solidified. Such a solidification process takes a large amount of time, and consequently, a manufacturing period of the power conversion apparatus is severely slowed down.

However, in this application, the power inductor is potted in a separate inductor cavity, and the inductor cavity directly serves as a part of a heat dissipation housing of the power conversion apparatus. In this way, the huge heat dissipation requirement of the power inductor is fully ensured, and the sealing reliability of the power conversion apparatus is improved. In addition, the power inductor is directly connected to the board by leading out a conductive metal strip. In this way, the possibility of the cable connection error caused by the cable is eliminated, installation procedures of the power inductor are simplified, the production period of the entire power conversion apparatus is shortened, the size of the entire power conversion apparatus is reduced, and the process aesthetics of the power conversion apparatus is greatly improved.

The following describes in detail the cable-free inductor and the photovoltaic inverter 20 including the cable-free inductor provided in embodiments of this application. It should be understood that the photovoltaic inverter 20 is merely an example. The cable-free inductor solution provided in embodiments of this application is applicable to another power conversion product including a power inductor.

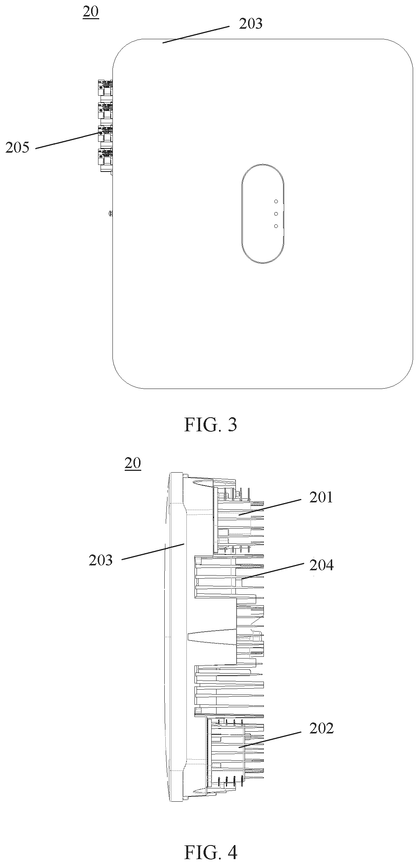

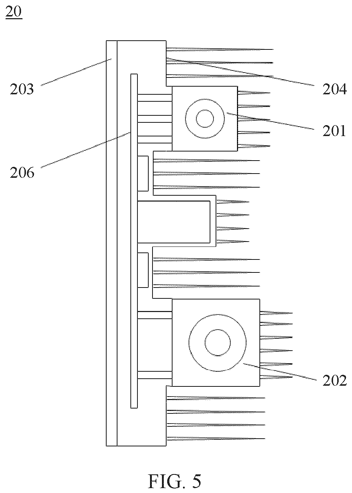

FIG. 2 is a diagram of a structure of a photovoltaic inverter 20 according to an embodiment of this application. FIG. 3 is a front view of a photovoltaic inverter 20 according to an embodiment of this application. FIG. 4 is a side view of a photovoltaic inverter 20 according to an embodiment of this application. FIG. 5 is a diagram of a cross-sectional structure of the photovoltaic inverter 20 shown in FIG. 3.

In an implementation, the photovoltaic inverter 20 includes a top housing 203, a bottom housing 204, a first power inductor 201, a second power inductor 202, and a PV port 205. The top housing 203, the bottom housing 204, the first power inductor 201, and the second power inductor 202 are jointly enclosed to form an outer surface of the photovoltaic inverter 20 (as shown in FIG. 2 to FIG. 4), and the PV port 205 is fastened to the bottom housing 204 (as shown in FIG. 2 and FIG. 3). The photovoltaic inverter 20 further includes a main circuit board 206, and the main circuit board 206 is fastened in an internal cavity S of the photovoltaic inverter 20 (as shown in FIG. 5).

In this implementation, the top housing 203 is of a plate-like structure. The main circuit board 206 is disposed parallel to the top housing 203. The bottom housing 204 is of a groove-shaped structure. Because the main circuit board 206 is disposed close to the top housing 203, the internal cavity S of the photovoltaic inverter 20 is divided into a first cavity S1 and a second cavity S2 by the main circuit board 206. The first cavity S1 is a cavity formed between the top housing 203 and a side that is of the main circuit board 206 and that faces the top housing 203. The second cavity S2 is a cavity formed between the bottom housing 204 and the side that is of the main circuit board 206 and that faces the bottom housing 204. Main electrical elements of the photovoltaic inverter 20 are all mounted on a side that is of the main circuit board 206 and that faces the bottom housing 204. Such a main electrical element, for example, a power module or a capacitor element, has a relatively large size and a high heat dissipation requirement. An electrical element that has a small size and a low heat dissipation requirement, for example, a signal indicator, a surface mount capacitor, and a surface mount resistor, is mounted on the side that is of the main circuit board 206 and that faces the top housing 203. Heat-dissipation fins are disposed on a side of the bottom housing 204 and that backs on the main circuit board 206. In this embodiment of this application, the element with the high heat dissipation requirement is disposed close to the bottom housing 204, so that a heat dissipation capability of the photovoltaic inverter 20 is improved. In addition, the bottom housing 204 is of the groove-shaped structure, and a distance between a surface of a groove and the main circuit board 206 is determined by a height of the electrical element close to the surface of the groove (a height of the electrical element in a direction perpendicular to the main circuit board 206). In this way, a size of the second cavity S2 is the smallest. The main circuit board 206 is disposed close to the top housing 203, so that the size of the first cavity S1 is the smallest. Therefore, the size of the entire photovoltaic inverter 20 can be reduced to a maximum extent, and the heat dissipation requirement of the electrical element is also ensured.

In the conventional technology in which a power inductor is integrated into a photovoltaic inverter, the following problem cannot be overcome. To be specific, in a production process of the photovoltaic inverter including a packaging process of a potting compound of the power inductor, packaging of the potting compound of the power inductor usually undergoes a long-time potting compound solidification phase. A plurality of electrical elements in the photovoltaic inverter should be assembled only after the potting compound of the power inductor is completely solidified. In this case, the packaging process of the potting compound of the power inductor occupies a large portion of a total production duration of the photovoltaic inverter. Consequently, a total production period of the photovoltaic inverter is too long.

In this implementation, a reserved through hole is provided on the bottom housing 204. Conductive components of the first power inductor 201 and the second power inductor 202 are connected to the main circuit board 206 through the reserved through hole on the bottom housing 204. Housings of the first power inductor 201 and the second power inductor 202 are connected to the bottom housing 204 by using a bolt, and may be independently detached and mounted relative to the photovoltaic inverter 20. In a production process of the photovoltaic inverter 20, the first power inductor 201 and the second power inductor 202 may be separately manufactured, packaged, and solidified in a factory, and then assembled into the photovoltaic inverter 20 after the production of the first power inductor 201 and the second power inductor 202 is completed. Production processes of the first power inductor 201 and the second power inductor 202 do not affect an assembly process of another electrical element of the photovoltaic inverter 20. Therefore, the total production period of the photovoltaic inverter 20 is greatly shortened.

Heat-dissipation fins are also disposed on outer surfaces of the first power inductor 201 and the second power inductor 202. When the photovoltaic inverter 20 works, heat generated by the power inductor may also be released through the heat-dissipation fins. The outer surfaces of the first power inductor 201 and the second power inductor 202, the bottom housing 204, and the top housing 203 are enclosed, through connecting by using a bolt and sealing by using a sealing ring (not shown in FIG. 2 to FIG. 5), to form the internal cavity S. It also meets a sealing requirement of the photovoltaic inverter 20. Refer to FIG. 5. An inductor coil and an inductor magnetic core are mounted inside the first power inductor 201 and the second power inductor 202. A pin led out by the inductor coil is directly fastened to the main circuit board 206 through a copper bar. In this way, the first power inductor 201 and the second power inductor 202 are directly connected to the main circuit board 206, so that problems, such as a cable connection error and complex installation that may be caused by cable connection, are avoided. In addition, the first power inductor 201 or the second power inductor 202, the main circuit board 206, and the top housing 203 are sequentially arranged in the direction perpendicular to the main circuit board 206. Compared with a manner in which the first power inductor 201 or the second power inductor 202 and the main circuit board 206 are arranged in a same plane, in the technical solution provided in this embodiment of this application, a projection area of the photovoltaic inverter in the direction perpendicular to the main circuit board 206 is greatly reduced, and arrangement compactness of the electrical elements of the photovoltaic inverter 20 is enhanced. This helps miniaturization and intensification of the photovoltaic inverter 20.

In an implementation, the first power inductor 201 and the second power inductor 202 each may be used as a boost circuit inductor and an inverter circuit inductor. The boost circuit inductor has three MPPT inputs.

The following describes in detail the first power inductor 201 and the second power inductor 202 provided in embodiments of this application.

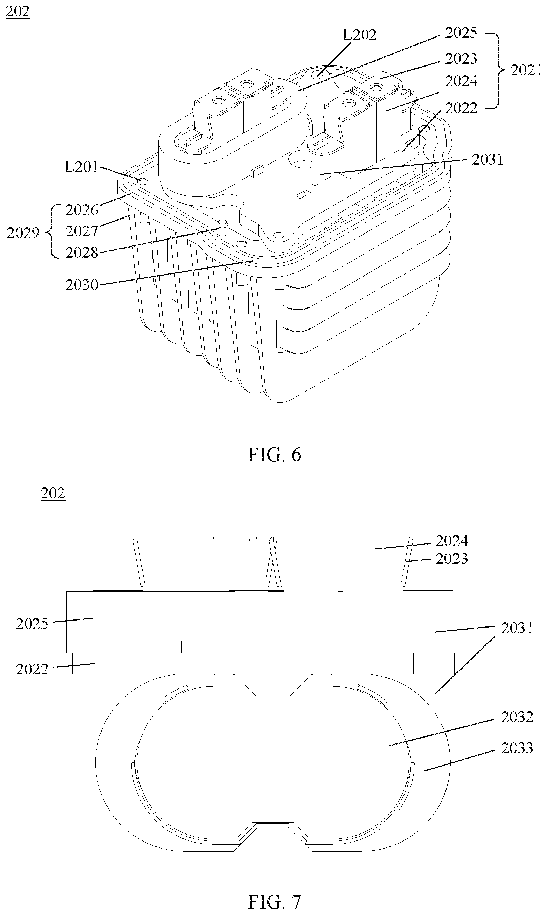

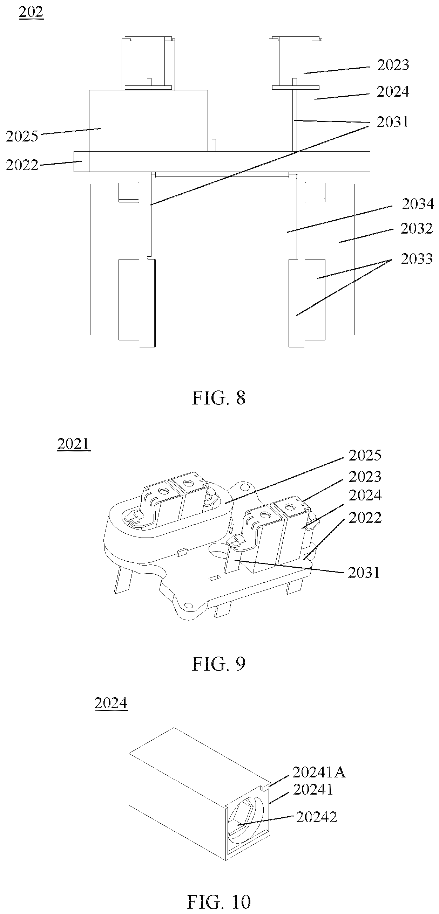

FIG. 6 is an axonometric diagram of a second power inductor according to an embodiment of this application. FIG. 7 is a side view of a second power inductor in which an inductor housing is hidden according to an embodiment of this application. FIG. 8 is a front view of a second power inductor in which an inductor housing is hidden according to an embodiment of this application.

In an implementation, with reference to FIG. 6, a second power inductor 202 includes an inductor housing 2029 and an inductor cover plate 2021. The inductor housing 2029 and the inductor cover plate 2021 are enclosed to form accommodation space S3. A magnetic core and a coil (not shown in FIG. 6) that are of the inductor are accommodated in the accommodation space S3. The inductor cover plate 2021 is detachable relative to the inductor housing 2029, and the inductor housing 2029 is fastened to the inductor cover plate through a bolt. L202 is a bolt through hole reserved for installing the bolt. In this implementation, there are two bolt through holes L202 respectively distributed at two diagonal ends of an inductor cover plate 2021. During factory production, the magnetic core and the coil that are of the inductor are first placed in the accommodation space S3. In the placement process, a position of the inductor cover plate 2021 should match the inductor housing. In other words, positions of the two bolt through holes L202 should correspond to threaded holes (not shown in FIG. 6) reserved on the inductor cover plate 2021. Then, bolts are fastened to the two bolt through holes L202, to ensure that the inductor housing 2029 and the inductor cover plate 2021 are relatively fastened. Then, a potting compound is potted in the accommodation space S3. After the potting compound is completely solidified, the second power inductor 202 may be assembled to a photovoltaic inverter 20.

In this implementation, the inductor housing 2029 includes heat-dissipation fins 2027, a housing connection portion 2026, and positioning pins 2028. Most of an outer surface of the inductor housing 2029 is designed to be the heat-dissipation fins. This helps quickly and efficiently release heat generated by a power inductor inside the inductor housing 2029, and control a temperature of the photovoltaic inverter 20 to maintain within a proper range, to ensure that the photovoltaic inverter 20 can work normally for a long time. In a working process of the photovoltaic inverter, the power inductor continuously dissipates heat to the outside. The heat is first transferred to the potting compound. The heat is relatively evenly transferred to an inner surface of the inductor housing 2029 through diffusion of the potting compound. After transferred to the heat-dissipation fins 2027 in a heat conduction process of a material of the inductor housing 2029, the heat is quickly released to an ambient environment. The housing connection portion 2026 is located on a periphery of an opening of the inductor housing 2029, and is of an annular strip-like structure. A center of the annular strip-like structure is configured to mount the magnetic core and the coil that are of the power inductor. The housing connection portion 2026 and the heat-dissipation fins 2027 are of an integrated structure. The annular strip-like structure has a specific width, on which positioning pins 2028, threaded holes L201, threaded holes matched with the bolt through holes L202, and a sealing ring groove 2030 are designed. There are two positioning pins 2028 respectively distributed on opposite sides of the housing connection portion and configured for positioning in a process in which the second power inductor 202 is mounted on the photovoltaic inverter 20. There are four threaded holes L201, each two of which are distributed on the opposite sides of the housing connection portion and configured for fastening between bolts of a bottom housing 204. The sealing ring groove 2030 is configured to accommodate a sealing ring, to enhance sealing between the bottom housing 204 and the second power inductor 202.

In this implementation, the inductor cover plate 2021 includes a magnetic ring 2025, a conductive metal strip 2023, a connection bracket 2024, and a cover plate body 2022. The cover plate body 2022 is of a plate-like structure. There is a coil through hole on the cover plate body 2022 to enable a coil end portion 2031 to pass through the cover plate body 2022. The coil end portion 2031 is a terminal led out by two ends of a coil 2034 (as shown in FIG. 7 and FIG. 8), is of a long strip plate-like structure, and is configured to implement an electrical connection to a main circuit board 206. To implement a cable-free electrical connection between the power inductor and the main circuit board 206, a solution of combining the conductive metal strip 2023 and the connection bracket 2024 is used in embodiments of this application. The conductive metal strip 2023 is of a Z-shaped plate-like structure. A through hole is provided on one end of the conductive metal strip 2023, to enable the coil end portion 2031 to perpendicularly insert into the through hole. The connection between the conductive metal strip 2023 and the coil end portion 2031 is fastened through welding. A threaded through hole is provided on the other end of the conductive metal strip 2023. The connection bracket 2024 is of a columnar structure, and is integrated with the cover plate body 2022. A threaded hole is provided on a center of the connection bracket 2024. During installation, the threaded hole, the threaded through hole on the other end of the conductive metal strip 2023, and the threaded through hole on the main circuit board 206 overlap with each other, to enable the bolt to pass through the main circuit board 206, the conductive metal strip 2023, and the connection bracket 2024. In this implementation, the connection bracket 2024 may have both functions of supporting the conductive metal strip 2023 and accommodating a connection component. Particularly, refer to FIG. 7. A bending angle of the Z-shaped structure of the conductive metal strip 2023 is an acute angle. In this way, there is specific deformation space for the conductive metal strip 2023 on a direction perpendicular to the cover plate body 2022 and on a connection parallel to the coil end portion 2031, so that a design tolerance requirement of the power inductor is reduced. The magnetic ring 2025 is sleeved on an outer side of the coil end portion 2031, the conductive metal strip 2023, and the connection bracket 2024, so that a current path formed between the coil 2034 and the main circuit board 206 passes through the middle of the magnetic ring 2025, to suppress common-mode interference. The magnetic ring 2025 is connected to the cover plate body 2022 through adhesive bonding. Particularly, a fixed protrusion portion (not shown in FIG. 6) is further disposed on the cover plate body 2022. The fixed protrusion portion and the cover plate body 2022 are integrally formed, to provide positioning of the magnetic ring 2025 for mounting, and limit movement of the magnetic ring 2025 along a plane of the cover plate body 2022. In another optional implementation, the magnetic ring 2025 may alternatively be positioned, limited, and fastened by using a buckle.

After the potting compound is completely solidified, when the second power inductor 202 is mounted on the photovoltaic inverter 20, the sealing ring already placed in the sealing ring groove 2030 is first aligned, based on the positioning pins 2028, with corresponding positioning pin holes on the bottom housing 204, and then is fastened at the four threaded holes L201 from a side of the bottom housing 204 by using bolts. The sealing ring fills a gap between the inductor housing and the bottom housing 204 through fastening and squeezing by the bolts, to isolate the inside of the photovoltaic inverter 20 from the outside of the photovoltaic inverter 20. Then, the connection bracketis fastened to the main circuit board 206 by using a bolt, and a part of the main circuit board 206 corresponding to the connection bracket is conductive. In this way, a current path is formed from the coil 2034, the coil end portion 2031, the conductive metal strip 2023, to the main circuit board 206. Therefore, a cable-free electrical connection between the second power inductor 202 and the main circuit board 206 is implemented.

In an implementation, with reference to FIG. 7 and FIG. 8, a part that is of the second power inductor 202 and that is immersed in the potting compound includes the coil 2034, the magnetic core 2032, and a framework 2033. In this implementation, there are two coils 2034. Each coil 2034 leads out two coil end portions 2031. The framework 2033 is partially fastened to the cover plate body 2022. The middle of the framework 2033 is configured to: accommodate and fasten the magnetic core 2032, and isolate direct contact between the coil 2034 and the magnetic core. The coil 2034 is wound on the magnetic core 2032. It should be understood that a quantity of coils 2034, a form of the magnetic core 2032, and a quantity of coil end portions 2031 led out by the coil 2034 and a lead-out manner may be adaptively changed based on a form of a circuit. This is not limited in this application.

In the technical solution provided in the foregoing embodiment of this application, after the second power inductor 202 is fastened to the bottom housing 204 and the main circuit board 206 through the bolts, in a first aspect, because the coil end portion 2031 and the conductive metal strip 2023 are not of an integrated structure, relatively large force may be generated at a joint between the coil end portion 2031 and the conductive metal strip 2023. To increase reliability of a connection between the coil end portion 2031 and the conductive metal strip 2023 and further reduce the design tolerance requirement, this application provides another embodiment of the inductor cover plate 2021. In a second aspect, creep effect may occur on the main circuit board 206. Consequently, a contact resistance between the conductive metal strip 2023 and the main circuit board 206 is increased, and poor contact between the two occurs. When the photovoltaic inverter works, a temperature at a joint between the two increases relatively quickly. In severe cases, fire occurs. To reduce impact of the creep effect of the main circuit board 206, this application provides another embodiment of the inductor cover plate 2021.

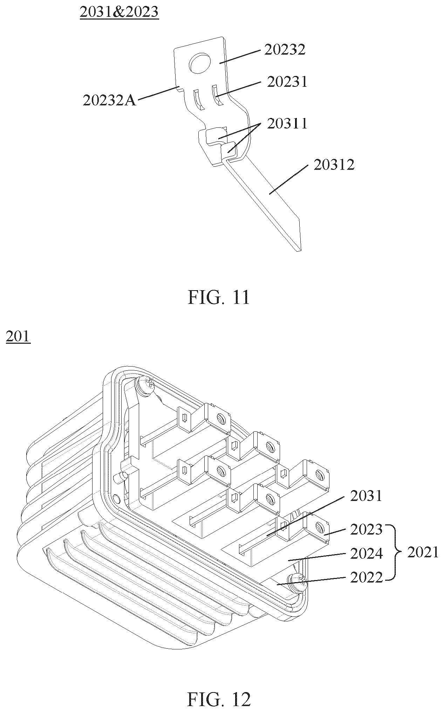

FIG. 9 is an axonometric diagram of an inductor cover plate according to an embodiment of this application. FIG. 10 is a diagram of a structure of a connection bracket according to an embodiment of this application. FIG. 11 is diagram of a structure of a connection between a conductive metal strip and a coil end portion according to an embodiment of this application.

In an implementation, with reference to FIG. 9, the inductor cover plate 2021 includes a magnetic ring 2025, a conductive metal strip 2023, a connection bracket 2024, and a cover plate body 2022. A relative position relationship between the magnetic ring 2025, the conductive metal strip 2023, the connection bracket 2024, and the cover plate body 2022, and structural forms of the magnetic ring 2025 and the cover plate body 2022 are similar to those in the embodiment shown in FIG. 6. For brevity, details are not described herein again. Differences lie in that, in a first aspect, to simplify an installation process and improve reliability of a connection between the conductive metal strip 2023 and the connection bracket 2024, this implementation provides a structure design for matching between the conductive metal strip 2023 and the connection bracket 2024. In a second aspect, to reduce a contact resistance between the conductive metal strip 2023 and a main circuit board 206, this implementation provides a structure design for a bending portion of the conductive metal strip 2023. In a third aspect, to improve reliability of a connection between the coil end portion 2031 and the conductive metal strip 2023, this implementation provides a structure design for a connection part between the conductive metal strip 2023 and the coil end portion.

The following describes the three structure designs in detail with reference to the accompanying drawings.

Refer to FIG. 10. The connection bracket 2024 includes a nut groove 20242 and a fixed side wall 20241. The nut groove 20242 is located in a hollow part that is of the connection bracket 2024 and that is close to the main circuit board 206. The nut groove 20242 is configured to accommodate a nut, and cooperates with a bolt, to implement a fastening connection between the connection bracket 2024, the conductive metal strip 2023, and the main circuit board 206. In an implementation, a flange nut may be placed in the nut groove, and a contact area between the flange nut and the conductive metal strip is relatively large. This helps ensure that the conductive metal strip is not deformed for a long time. The fixed side wall 20241 is located on a top edge that is of the connection bracket 2024 and that is connected to the conductive metal strip 2023. A main part of the fixed side wall 20241 is located on three sides of four sides of a rectangular top edge of the connection bracket 2024, and the fixed side wall and the connection bracket 2024 are integrally formed. The fixed side wall 20241 further includes a notch side wall 20241A. The notch side wall 20241A is located on another side of the four sides of the rectangle other than the three sides. A length of the notch side wall 20241A occupies only a small portion of a length of the side where the fixed side wall 20241 is located. In this case, the notch side wall 20241 A is enclosed to form a groove with a notch. After the conductive metal strip 2023 is embedded in the groove, movement of the conductive metal strip 2023 on a plane parallel to the main circuit board 206 is limited due to existence of the fixed side wall 20241 . Due to the existence of the fixed side wall 20241, a process in which the connection bracket 2024 is located by the conductive metal strip 2023 is easier, and an installation process may be simplified. In addition, a connection between the conductive metal strip 2023 and the connection bracket 2024 is more reliable.

Refer to FIG. 11. The conductive metal strip 2023 includes bending portion notches 20231 and a bolt connection portion 20232. With reference to FIG. 7, the conductive metal strip 2023 is of a Z-shaped structure. Two bending portion notches 20231 are provided on a bending portion that is of the conductive metal strip 2023 and that is close to the main circuit board 206. Due to existence of the bending portion notch 20231, a capability of deformation of the bending portion on which the bending portion notch 20231 is located may be greatly enhanced. In an implementation of this application, in a direction perpendicular to a plane on which the main circuit board is located, the bending portion that is of the conductive metal strip and that is with the bending portion notches 20231 may be deformed, so that the conductive metal strip 2023 always keeps in contact with the main circuit board 206. Therefore, an excessively large contact resistance at a joint between the conductive metal strip 2023 and the main circuit board 206 is avoided. The bolt connection portion 20232 further includes an embedding portion 20232A. A shape of the embedding portion 20232A is consistent with that of the notch side wall 20241A. When the conductive metal strip 2023 is fastened to the connection bracket 2024, the embedding portion 20232A and the notch side wall 20241A are interlocked with each other.

Still refer to FIG. 11. The coil end portion 2031 includes buckles 20311 and a port plate 20312. The port plate 20312 is of a long rectangular strip plate-like structure. One end of the port plate is connected to a coil 2034 (not shown in FIG. 11), and the other end of the port plate 20312 is forked from the middle, to form two buckles 20311 . In this implementation of this application, the two buckles 20311 are respectively bent in two opposite directions, and the two buckles 20311 are perpendicular to the port plate 20312. A notch is provided on one end that is of the conductive metal strip 2023 and that is connected to the coil end portion 2031. During connection, the two buckles 20311 pass through the notch, so that the conductive metal strip 2023 and the coil end portion 2031 are interlocked with each other. Therefore, the reliability of the connection between the conductive metal strip 2023 and the coil end portion 2031 is greatly improved. It should be understood that a quantity of the buckles 20311 (for example, three) or a bending direction of the buckles 20311 (for example, the two buckles are bent in a same direction) may change. This is not limited in this application.

FIG. 12 is an axonometric diagram of a first power inductor according to an embodiment of this application.

In an implementation, a first power inductor 201 includes an inductor housing 2029 (not shown in FIG. 12) and an inductor cover plate 2021. The inductor cover plate 2021 includes a cover plate body 2022, a connection bracket 2024, and a conductive metal strip 2023. For brevity, the first power inductor 201 has a structure similar to that of a second power inductor 202. Details are not described herein again. A difference lies in that, because the first power inductor is a boost circuit inductor and has three MPPT inputs, the first power inductor 201 includes three coils (not shown in FIG. 12). The three coils lead out six coil end portions 2031. To match the six coil end portions 2031, there are six connection brackets 2024 and six conductive metal strips 2023, and the six connection brackets are symmetrically arranged on the cover plate body 2022. Because the first power inductor 201 and the second power inductor 202 are located in different circuits, the first power inductor 201 does not include a magnetic ring.

In an actual application process, a quantity of power inductors may be modified based on different circuit structures in a photovoltaic inverter. Alternatively, a quantity of coils of the power inductor and a specific structure form of the cover plate body may be adaptively modified based on different functions of the power inductor in a circuit and different specifications of the power inductor. It should be understood that the foregoing modifications do not go beyond the protection scope of this application.

The photovoltaic inverter and the cable-free power inductor provided in embodiments of this application are described in detail above. The principles and embodiments of this application are described herein by using specific examples. The description about the foregoing embodiments is merely provided to help understand the method and core ideas of this application. In addition, a person of ordinary skill in the art can make variations and modifications in terms of the specific embodiments and application scopes according to the ideas of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An inverter, comprising a top housing, a bottom housing, a power inductor, and a main circuit board, wherein
the top housing and the bottom housing are enclosed to form an accommodation cavity, the main circuit board is mounted in the accommodation cavity, and a plane on which the main circuit board is located is parallel to a plane on which the top housing is located; and
the bottom housing comprises a through hole, the through hole is configured for the power inductor to pass through the bottom housing along a first direction and to connect to the main circuit board, and the first direction is a direction perpendicular to the plane on which the main circuit board is located.

2. The inverter according to claim 1, wherein
the power inductor comprises an inductor housing, an inductor cover plate, a magnetic core, and a coil, the inductor housing and the inductor cover plate are enclosed to form accommodation space, the magnetic core and the coil are located in the accommodation space, and the coil is wound around the magnetic core; and
the inductor cover plate comprises a connection bracket, the connection bracket is located on a side that is of the inductor cover plate and that is away from the coil, and the connection bracket is configured to support a conductive component between the power inductor and the main circuit board.

3. The inverter according to claim 2, wherein
the inductor cover plate comprises a coil through hole and a conductive metal strip, the coil passes through the inductor cover plate through the coil through hole, one end of the conductive metal strip is connected to the main circuit board, the other end of the conductive metal strip is connected to the coil, and the power inductor is electrically connected to the main circuit board through the conductive metal strip.

4. The inverter according to claim 3, wherein the inductor cover plate comprises a magnetic ring, the magnetic ring is fastened to the inductor cover plate, the magnetic ring is disposed around the connection bracket, and a power line formed by connecting the conductive metal strip and the coil passes through the magnetic ring.

5. The inverter according to claim 2, wherein
the connection bracket comprises a hollow structure, the hollow structure is provided with a nut groove, a nut is disposed in the nut groove, one end of the main circuit board and one end of the conductive metal strip each comprise a through-hole structure, the through-hole structure is configured to allow a bolt to pass through and be fastened to the nut, and the power inductor is rigidly connected to the main circuit board through the conductive metal strip.

6. The inverter according to claim 5, wherein
the connection bracket is of a square columnar structure, a fixed side wall is provided on a peripheral edge that is of the connection bracket and that is close to a surface of the main circuit board, the fixed side wall is a protrusion structure with a notch, the fixed side wall is distributed on three sides of the peripheral edge, and the fixed side wall is distributed on a part of another side of the peripheral edge.

7. The inverter according to claim 3, wherein
the conductive metal strip is of a Z-shaped plate-like structure, a port of the coil is of a plate-like structure, the conductive metal strip is perpendicular to the port of the coil, the port of the coil passes through the conductive metal strip, and the port of the coil is fastened to the conductive metal strip.

8. The inverter according to claim 3, wherein
the conductive metal strip is of a Z-shaped plate-like structure, a port of the coil comprises a buckle and a port plate, the port plate is of a plate-like structure, one end of the port plate is connected to the coil, and the other end of the port plate is connected to the buckle; and
the buckle and the port plate are integrally formed, two buckles are perpendicular to the port plate and parallel to the conductive metal strip, the two buckles are bent in two opposite directions, and at least one of the two buckles is located on a side that is of the conductive metal strip and that faces the main circuit board.

9. The inverter according to claim 7 or 8, wherein
the conductive metal strip of the Z-shaped plate-like structure comprises two bending portions, and at least one of the two bending portions is provided with a bending portion notch.

10. The inverter according to claim 2, wherein
the power inductor comprises a sealing groove and a sealing ring, the sealing groove is provided on a periphery on one side that is of the inductor housing and that is close to the inductor cover plate, the sealing ring is embedded in the sealing groove, and the sealing ring is configured to seal the bottom housing and the inductor housing.

11. The inverter according to claim 2, wherein
the power inductor comprises a potting compound, the potting compound is potted in the accommodation space, and the potting compound is configured to immerse the magnetic core and the coil.

12. The inverter according to claim 2, wherein
heat-dissipation fins are disposed on outer surfaces of both the bottom housing and the inductor housing.

13. The inverter according to claim 2, wherein
the inductor housing and the inductor cover plate are detachable from each other, and the inductor housing is rigidly connected to the inductor cover plate through a bolt.

14. The inverter according to claim 2, wherein
the inductor housing is rigidly connected to the bottom housing through a bolt.

15. An inductor apparatus, wherein
the inductor apparatus comprises an inductor housing, an inductor cover plate, a magnetic core, and a coil, the inductor housing and the inductor cover plate are enclosed to form accommodation space, the magnetic core and the coil are located in the accommodation space, and the coil is wound around the magnetic core; and
the inductor cover plate comprises a connection bracket, the connection bracket is located on a side that is of the inductor cover plate and that is away from the coil, and the connection bracket is configured to support a conductive component between the inductor apparatus and a circuit board.
